(19) Europäisches Patentamt European Patent Office Office européen des brevets

(11) **EP 1 499 923 B1**

(12) **EUROPEAN PATENT SPECIFICATION**

(45) Date of publication and mention
of the grant of the patent:
**21.09.2011 Bulletin 2011/38**

(51) Int Cl.:
***G03F 7/033*** (2006.01)   ***B41M 1/04*** (2006.01)

(21) Application number: **04729904.5**

(86) International application number:
**PCT/EP2004/050635**

(22) Date of filing: **28.04.2004**

(87) International publication number:
**WO 2004/097523 (11.11.2004 Gazette 2004/46)**

(54) **PHOTOPOLYMERIZABLE COMPOSITIONS AND FLEXOGRAPHIC PRINTING PLATES DERIVED THEREFROM**

FOTOPOLYMERISIERBARE ZUSAMMENSETZUNGEN UND DARAUS HERGESTELLTE FLEXODRUCKPLATTEN

COMPOSITIONS PHOTOPOLYMERISABLES ET PLAQUES D'IMPRESSION FLEXOGRAPHIQUES PRODUITES AVEC CES COMPOSITIONS

(84) Designated Contracting States:
**AT BE BG CH CY CZ DE DK EE ES FI FR GB GR HU IE IT LI LU MC NL PL PT RO SE SI SK TR**

(30) Priority: **29.04.2003 EP 03076253**

(43) Date of publication of application:
**26.01.2005 Bulletin 2005/04**

(73) Proprietor: **KRATON Polymers Research B.V.
1030 BH Amsterdam (NL)**

(72) Inventors:
• **Muyldermans, Xavier,
Kraton Polymers Research S.A.
1348 Ottignies-Louvain-La-Neuve (BE)**

• **Roumache, Olivier,
Kraton Polymers Research S.A.
1348 Ottignies-Louvain-La-Neuve (BE)**

(74) Representative: **Kortekaas, Marcel C.J.A. et al
Exter Polak & Charlouis B.V. (EP&C)
P.O. Box 3241
2280 GE Rijswijk (NL)**

(56) References cited:
**WO-A-02/057386     US-B2- 6 531 263**

## Description

## Background Art

Photopolymerizable printing plates are known for use in making flexographic printing forms. The printing surface is produced by exposing a photopolymerizable layer image-wise to actinic radiation and subsequently removing the unexposed, non photopolymerized areas of the printing plate. Examples are found in the following patents:

GB 1366769 **--.**

,
US 4266005

,
US 4320188--.

,
US 4126466 --.

,
US 4430417 --.

,
US 4460675 --.

and
US 5213948 --.

Such photopolymerizable printing plates usually comprise a support, an optional adhesive layer or other underlayer, one or more photopolymerizable layers, an optional elastomeric intermediate layer and a cover layer.

A preferred method for making such multilayer photopolymerizable printing plates is by a process in which a previously extruded photopolymerizable composition is fed into the nip of a calendar and is calendered between a support layer and a cover layer, thus forming a photopolymerizable layer between them.

EP 0084851 A --.

disclosed a preparation method for a multilayer photopolymerizable printing plate, having an added elastomeric layer between the cover layer and the photopolymerizable layer.

The photopolymerizable layers contain polymeric binders, photopolymerizable monomers, photo-initiators, and added auxiliaries such as plasticizers, fillers, stabilizers etc.

The polymeric binders are usually thermoplastic elastomeric block copolymers, as disclosed in e.g.

GB 1366769 -.

These are generally block copolymers of the general formulae A-B-A or $(AB)_n$ or $(AB)_nX$, comprising thermoplastic blocks A and elastomeric blocks B, particularly linear and radial block copolymers with poly(monovinyl aromatic hydrocarbon) end blocks. Examples of such block copolymers include the following or mixtures of said block copolymers:

**Table 1**

| S-I-S | polystyrene/polyisoprene/polystyrene |
|---|---|
| S-B-S | polystyrene/polybutadienelpolystyrene |
| $(S-I)_4Si$ | tetra(polystyrene/polyisoprene)silane |
| $(S-B)_4Si$ | tetra(polystyrene/polybutadiene)silane |

The use of block copolymers having a certain vinyl content was also known for special purposes, such as those for improving printing plate properties with special monomers as disclosed in

EP 0525206 A--.

, or for preparing printing plates without monomer addition.

The polystyrene/polybutadiene/polystyrene and polystyrene/ polyisoprene/polystyrene block copolymers or mixtures thereof were preferred until now for making flexographic printing forms. Nevertheless, the current state of the art printing relief forms do not always meet the present requirements for flexographic printing. More in particular, when S-I-S block copolymers are used, the obtained flexographic printing plates show a too low and hence unattractive Shore A hardness, and also have the tendency for degradation causing unwanted surface stickiness; when S-B-S block copolymers are used, the obtained flexographic printing plates show a bad processing stability leading to gel formation and resulting bad resolution of the final developed plate; and when mixtures of said both block copolymers are used, the transparency of the flexographic printing plate is bad.

It would be highly advantageous for formulators of printing plates to have the flexibility to adjust properties by mixing SIS and SBS polymers. However, the resulting incompatibility leads to haziness and UV scattering limiting the resolution.

In this problem has also been recognized and a solution is provided comprising a photopolymerizable composition which comprises a mixture of SIS and SBS block copolymers as binder, ethylenically unsaturated monomers, plasticizer and photoinitiator, wherein the SIS block copolymer may be a conventional block copolymer (e.g., KRATON® D1161), but wherein the SBS block copolymer is selected to have a vinyl bond content in the range from 50 to 60% (e.g., KRATON® D kx222). Albeit that crystal-clear photopolymerizable flexographic printing elements are produced, the person skilled in the art will be severely limited in his choice of feedstock material.

The present invention overcomes this problem. The incorporation of both isoprene and butadiene into the rubber block gives the unexpected result of excellent transparency, and a desirable balance of processing stability, and plate hardness. Furthermore, surprisingly, this excellent transparency is preserved when the S(I/B)S block copolymer is mixed with either SIS and/or SBS type block copolymers. This gives the formulator further flexibility.

Therefore it is an object of the present invention to provide photopolymerizable compositions, which have to show an improved combination of processing stability, low melt viscosity and transparency while the flexographic printing plates derived from them have to show an improved combination of Shore A hardness, transparency and solvent resistance.

Another object of the present invention is to provide improved flexographic printing relief forms, prepared from said plates aimed at by selective image-wise irradiation through a mask and subsequent removal of non photopolymerized polymer.

## Disclosure of Invention

As result of extensive research and experimentation, said photopolymerizable compositions aimed at have now been surprisingly found.

Accordingly the present invention relates to a photopolymerizable composition, which comprises:

(a) from 20 to 98.9 % by weight, based on the weight of components (a) and (b) of one or more thermoplastic elastomeric block copolymers comprising a thermoplastic elastomeric block copolymer of the formulae

A-C-A (1) or (A-C)$_n$X (2)

wherein each A independently represents a polymer block of predominantly a monovinyl aromatic hydrocarbon having an apparent molecular weight in the range of from 7,000 to 25,000, wherein n is an integer equal to or greater than 2 and wherein X is the residue of a coupling agent, and wherein each C independently represents a substantially random copolymer block (I/B) of predominantly isoprene and butadiene in a mutual weight ratio in the range of from 20/80 to 80/20, wherein said polymer block C has a glass transition temperature (Tg) of at most 0°C, (determined according to ASTM E-1356-98), and having a vinyl bond content (the 1,2 and/or 3,4-addition polymerization of the isoprene and butadiene) in the range of from 5 to 70 mole%, said thermoplastic block copolymer having a poly (monovinyl aromatic hydrocarbon) content in the range of from 10 to 45 wt% and having an apparent molecular weight of the complete block copolymer in the range of from 100,000 to 1,500,000,

(b) from 1 to 60 % by weight, based on the weight of components (a) and (b), of one or more photopolymerizable ethylenically unsaturated low molecular weight compounds,

(c) from 0.1 to 10 % by weight, based on the total photomerizable composition of one or more polymerization initiators, and optionally

(d) from 0 to 40 % by weight, based on the total photopolymerizable compositions, of one or more auxiliaries.

The present invention also relates to improved flexographic printing plates derived from said photopolymerizable compositions and to flexographic printing relief forms produced therefrom.

**Mode for the Invention**

The monovinyl aromatic monomer is typically selected from styrene, $C_1$-$C_4$ alkylstyrene and $C_1$-$C_4$ dialkylstyrene, in particular styrene, $\alpha$-methylstyrene, o-methylstyrene or p-methylstyrene, 1,3-dimethylstyrene, p-tert-butylstyrene, vinyl naphtalene or mixtures thereof. Styrene is the most preferred monomer. With the term "predominantly vinyl aromatic hydrocarbon", as used throughout the specification, is meant that for the respective blocks to be prepared, a substantially pure monovinyl aromatic hydrocarbon and preferably styrene or mixtures comprising at least 95 wt% of monovinyl aromatic hydrocarbon and preferably styrene and minor amounts of other comonomers can be used. The small proportions of other comonomers in the preferably polystyrene blocks can consist of structurally related comonomers such as alpha-methyl styrene, p-methyl styrene, o-methyl styrene, p-tert.butyl styrene, dimethyl styrene and vinyl naphtalene, or butadiene and/or isoprene. It will be appreciated that in preferred block copolymers used as component (a) the poly(monovinyl aromatic hydrocarbon) blocks will consist of substantially pure poly(styrene).

With the term "predominantly isoprene and butadiene", as used throughout the specification, is meant that for the respective blocks to be prepared, a substantially pure isoprene/butadiene mixture comprising at least 95 wt% of isoprene and butadiene and minor amounts of other comonomers can be used. The small proportions of other comonomers in the poly(isoprene/butadiene) block can consist of structurally related alkadienes and/or styrene and/or its related comonomers as mentioned hereinbefore.

Preferred block copolymers to be applied according to the present invention contain blocks of substantially pure styrene and block(s) of mixtures of substantially pure isoprene and butadiene.

In preferred compositions, the mutual weight ratio between isoprene and butadiene in the I/B blocks is in the range according to the equation:

$$-30 < 40 + V - I < 30$$

wherein I is the average isoprene content in the I/B block and "V" is the average molar ratio in percent of 1,2 or 3,4 addition polymerization in the I/B blocks.

The block copolymer according to the present invention may be branched or linear and may be a triblock, tetrablock or multiblock, but it must contain at least two poly(monovinyl aromatic) blocks and preferably two poly(styrene) blocks.

With the term "substantially at random polymerized mixtures of isoprene and butadiene" is actually meant that the central (1/B) blocks only contain average homopolymer block lengths of less than 100 monomer units and preferably of less than 50 monomer units and more preferably of less than 20 monomer units, resulting in only one peak on loss tangent (tan $\delta$). Said average homopolymer block length may be determined by various methods. The method used in the present application is based on carbon-13 NMR and said method has been disclosed in detail in WO 02057386 -., pages 12, 13, 14 and 15.

The polymer blocks S have an apparent molecular weight in the range of from 7,000 to 25,000 and preferably from 10,000 to 15,000.

The poly(monovinyl aromatic hydrocarbon) content and preferably poly(styrene) content (PSC) in said block copolymers is in the range of from 10 to 45 wt%, preferably from 14 to 25 wt% and more preferably from 15 to 20 wt%.

The block copolymers to be used according to the present invention preferably contain 1,2-vinyl bonds and/or 3,4 vinyl bonds in a proportion of at most 70 mole%, based on the molar ratio of conjugated diene and is preferably in the range of from 5 to 40 mole%.

More preferred weight proportions of component (a) are in the range of from 20 to 80 wt%.

As indicated, component (a) may also be a mixture of the thermoplastic elastomeric block copolymer of the formulae

$$A\text{-}C\text{-}A \ (1) \ \text{or} \ (A\text{-}C)_n X \ (2)$$

and a regular block copolymer of the general formulae A-B-A, (A-B)n or [A-B]$_n$ X, typically an S-I-S or S-B-S block copolymer. In case a mixture is used, then the polymer having a substantially random copolymer block of predominantly isoprene and butadiene comprises at least 30% by weight on component (a), preferably at least 50% by weight. If blends of block copolymers are used, it may be beneficial to include an S-B-S polymer with a high vinyl content

The block copolymers according to the present invention can be prepared by full sequential polymerization of predetermined batches of predominantly monovinyl aromatic hydrocarbon monomer, of isoprene/butadiene mixtures and of predominantly monovinyl aromatic hydrocarbon respectively (for triblock copolymers S-(I/B)-S) by anionic polymerization in an inert organic solvent, or by coupling of an initially prepared living diblock copolymer, obtained by sequential polymerization of predetermined batches of predominantly monovinyl aromatic hydrocarbon and of predominantly isoprene/butadiene by anionic polymerization in an inert organic solvent, with a coupling agent (to provide triblock or multiblock copolymers).

In both preparation methods the remaining living block copolymers have to be terminated by addition of a proton donating agent, such as an alkanol, e.g. ethanol or water.

It will be appreciated that block copolymers, prepared by means of coupling of living diblock copolymers by means of a coupling agent and termination of remaining living block copolymers will finally contain diblock copolymer, having the same S blocks. Diblock content, if any, is preferably less than 40% by weight on the basis of the block copolymers used as component (a).

Similarly, it will be appreciated that block copolymers, prepared by means of the process disclosed in EP 0691991 A--.

will finally contain diblock copolymer, having the same S blocks. Said European patent specification disclosed a process involving full sequential polymerization of a first linear block copolymer and polymerization of a second block copolymer, while polymerizing the first linear block copolymer by adding a second batch of initiator at a predetermined moment during the preparation of the first block copolymer.

As examples of the coupling agent may be mentioned tin coupling agents such as tin dichloride, monomethyltin dichloride, dimethyltin dichloride, monoethyltin dichloride, diethyltin dichloride, methyltin trichloride, monobutyltin dichloride, dibutyltin dibromide, monohexyltin dichloride and tin tetrachloride; halogenated silicon coupling agents such as dichlorosilane, monomethyldichlorosilane, dimethyldichlorosilane, diethyldichlorosilane, monobutyldichlorosilane, dibutyldichlorosilane, monohexyldichlorosilane, dihexyldichlorosilane, dibromosilane, monomethyldibromosilane, dimethyldibromosilane, silicon tetrachloride and silicon tetrabromide; alkoxysilanes such as tetramethoxysilane; divinyl aromatic compounds such as divinylbenzene en divinyl naphthalene; halogenated alkanes such as dichloroethane, dibromoethane, methylene chloride dibromomethane, dichloropropane, dibromopropane, chloroform, trichloroethane, trichloropropane and tribromopropane; -halogenated aromatic compounds such as dibromobenzene; epoxy compounds such as the diglycidyl ether of bisphenol-A (e.g. EPON™ 825 or 826), and other coupling agents such as benzoic esters, $CO_2$, 2-chloroprene and 1-chloro-1,3-butadiene and diethyladipate or dimethyladipate. Of these EPON diglycidyl ethers, dibromobenzene, tetramethoxysilane and dimethyldichlorosilane are preferred.

The apparent molecular weights of the complete block copolymers and each of the intermediate precursors have been determined by Gel Permeation Chromatography, and expressed in terms of standard poly(styrene), (analogous to the method described in ASTM D5296-97). The block copolymers used as component (a) typically have an apparent molecular weight in the range of 100,000 to 1,500,000, with a preferred upper limit of 500,000 in case of linear block copolymers.

In general, the polymers useful in this invention may be prepared by contacting the monomer or monomers with an organoalkali metal compound in a suitable solvent at a temperature within the range from -150°C to 300°C, preferably at a temperature within the range from 0°C to 100°C. Particularly effective polymerization initiators are organolithium compounds having the general formula

RLi

wherein R is an aliphatic, cycloaliphatic, alkyl-substituted cycloaliphatic, aromatic or alkyl-substituted aromatic hydrocarbon radical having from 1 to 20 carbon atoms of which sec.butyl is preferred.

Suitable solvents include those useful in the solution polymerization of the polymer and include aliphatic, cycloaliphatic, alkyl-substituted cycloaliphatic, aromatic and alkyl-substituted aromatic hydrocarbons, ethers and mixtures thereof. Suitable solvents, then, include aliphatic hydrocarbons such as butane, pentane, hexane and heptane, cycloaliphatic hydrocarbons such as cyclopentane, cyclohexane and cycloheptane, alkyl-substituted cycloaliphatic hydrocarbons such as methylcyclohexane and methylcycloheptane, aromatic hydrocarbons such as benzene and the alkyl-substituted hydrocarbons such as toluene and xylene, and ethers such as tetrahydrofuran, diethylether and di-n-butyl ether. Preferred solvents are cyclopentane or cyclohexane.

The block copolymers according to the general formulae (1) and (2) can be made by mere adaptation of common processes used for the preparation of S-B-S type block copolymers and/or S-I-S type block copolymers, using a mixture of butadiene/isoprene instead. Of importance in the preparation of the block copolymers according to the present invention is to avoid homopolymer block formation, to ensure appropriate B/I ratio, and to produce a polymer block wherein the random midblock has a Tg of 0°C or less.

Techniques to enhance the vinyl content of the butadiene portion are well known and may involve the use of polar compounds such as ethers, amines and other Lewis bases and more in particular those selected from the group consisting of dialkylethers of glycols. Most preferred modifiers are selected from dialkylether of ethylene glycol containing the same or different terminal alkoxy groups and optionally bearing an alkyl substituent on the ethylene radical, such as monoglyme, diglyme, diethoxyethane, 1,2-diethoxy-propane, 1-ethoxy-2,2-tert-butoxyethane, of which 1,2-diethoxypropane is most preferred.

It may also be beneficial to adapt the process by adding one or both comonomers during the formation of the mixed midblock.

The photopolymerizable compositions to be used according to the present invention comprise as component (b) addition polymerizable ethylenically unsaturated compounds selected from monounsaturated or polyunsaturated monomers, such as e.g. esters or amides of acrylic acid or methacrylic acid with monofunctional or polyfunctional alcohols, amines, aminoalcohols and hydroxyethers or hydroxyesters.

Also suitable are mixtures of monounsaturated and polyunsaturated compounds, as described in
US 5472824 --.
and
US 5472824 --.

More specific examples of addition polymerizable compounds are butyl acrylate; isodecyl acrylate; 1,6-hexanediol dimethacrylate; 1,6-hexanediol diacrylate; trimethylolpropane triacrylate and dipentaerythritol monohydroxypentacrylate.

More preferred weight proportions of component (b) are in the range of from 5 to 30 % by weight, relative to the weight of components (a) and (b).

The photopolymerizable compositions also comprise one of the known photoinitiators or photoinitiator systems, as components (c), e.g. methylbenzoin, benzoin acetate, benzophenone, benzil dimethyl-ketal or ethyl anthraquinone/4,4-bis(dimethyl amiano)benzo-phenone.

More preferred weight proportions of component (c) are in the range of from 0.5 to 5% by weight, relative to the weight of the total copolymerizable composition.

Examples of auxiliaries mentioned as component (d) include plasticizers, aromatic resin, additional compatible rubber, fillers, dyes and/or pigments, antioxidants, antiozonants, thermal polymerization inhibitors and liquid poly(isoprene), liquid poly(butadiene) and/or liquid S-B or S-I diblock copolymers.

It will be appreciated that the flexographic printing plates according to the present invention can additionally comprise a support layer, which may consist of sheets of various film-forming synthetic polymers. Polyester and polyester/polyamide sheets, optionally having-an adhesive layer and/or antihalation layer, are preferred , and in particular polyethylene terephtalate sheets.

Moreover said flexographic printing plates may also comprise a cover element, which is usually composed of a flexible cover film, optionally a flexible polymeric film and/or a layer of elastomeric composition.

The flexible cover film has to be removed before irradiation. This removal can be facilitated by a fine sheet of release agent between the flexible cover film and the flexible layer of polymeric film and/or a layer of elastomeric composition.

If present this elastomeric layer comprises at least one block copolymer as specified hereinbefore.

The photopolymerizable compositions to be used according to the present invention can be prepared in a conventional manner by homogeneously mixing the individual components, for example in solution, or in a kneader, a mixer or an extruder.

Said compositions have good processability and layers of the desired thickness can be produced from the composition by e.g. casting a solution in a suitable solvent, such as toluene, xylene, cyclohexane, cyclopentane, tetrahydrofuran, methyl isobutyl ketone or tetrachloro ethylene, on a appropriate base. Layers of the composition can also be produced by compression molding extrusion and calendaring, and when a suitable process temperature, combined with a suitable inhibitor is used, no incipient thermal cross linking will occur.

The thickness of the layers can be varied within wide limits and can easily be chosen to suit a particular application. The thickness of the layers is usually in the range of from 0.01 to 6.5 mm.

The flexographic printing plate is exposed image-wise through a negative by commonly used methods. The cover layer of the flexographic printing plate is removed as usual before image-wise exposure. Any type and source of actinic radiation can be used to prepare the flexographic printing relief forms. Suitable radiation sources are, for example, mercury vapour lamps, incandescent lamps with special phosphors that emit ultraviolet light, argon incandescent lamps and photo lamps. The most suitable among these are mercury vapour lamps, particularly ultraviolet light lamps, and ultraviolet fluorescent lamps.

An overall backside exposure can be made before or after image-wise exposure. This exposure can be diffuse or directional. The exposure source can be all of the radiation sources conventionally used for the image-wise exposure.

Unphotopolymerized areas of the printing plate can be washed off with suitable developer solutions, such as , for example, aliphatic or aromatic hydrocarbons such as n-hexane, petroleum ether, hydrogenated petroleum fractions, limonene or other terpenes, toluene, isopropyl benzene etc., ketone such as, for example, methylethyl ketone, halogenated hydrocarbons such as chloroform, trichloroethane or tetrachloroethane, esters such as, for example, acetic esters, acetoacetic acid esters or mixtures of these solvents. Additives such as surfactants or alcohols are possible constituents. After being dried, the resulting printing forms can be post-exposed or posttreated chemically in any sequence to make a non-tacky printing surface.

The flexographic printing plates of the present invention have surprisingly been found to show an improved transparency as compared to those derived from pure mixtures of S-I-S and S-B-S block copolymers, a suitable hardness range and improved process stability, as compared to either S-I-S or S-B-S block copolymer. The flexographic printing plates of the present invention also exhibit a good solvent resistance and transparency.

It will be appreciated that an important advantage of the flexographic printing plates of the present invention is, that they are transparent for visible and UV light, which enables a high quality sharpness in the subsequent flexographic printing plates.

Examples

The invention will now be described in more detail by the following examples, however without restricting its scope to these embodiments.

Ingredients description

**Table 2 (Rubbers)**

| Polymer names | Block structures and nature | I/B weight ratio in rubber | PSC (%w) | Main structureG PC Mw (kg/mole) | Tri-block content (%w) | % Vinyl in rubber mole% (+/-3%) |
|---|---|---|---|---|---|---|
| SIS1 | SIS/SI | 100/0 | 15 | 222 | 80 | 10 |
| SIS2 | SIS | 100/0 | 19 | 178 | 100 | 10 |
| SIS3 | SIS/SI | 100/0 | 30 | 141 | 83 | 10 |
| SBS1 | SBS/SB | 0/100 | 31 | 172 | 84 | 10 |
| SBS2 | SBS/SB | 0/100 | 29 | 126 | 85 | 10 |
| S(I/B)S1 | S(I/B)S/S(I/B) | 60/40 | 19 | 184 | 75 | 10 |
| S(I/B)S2 | (S(I/B))$_{2.9}$/S(I/B)* | 50/50 | 30 | 230/320 / 402** | 76*** | 10 |
| S(I/B)S3 | S(I/B)S* | 75/25 | 18.5 | 171 | 100 | 33 |
| Liq SI | SI | 100/0 | 13 | 30 | 0 | 10 |
| Liq PB | PB | 0/100 | 0 | 4.1 | 0 | 55 |

[0062] * S(I/B)S and S(I/B)S$_2$ are respectively coupled with a di and tetrafunctional coupling agent; S(I/B)S$_3$ is sequentially polymerized

[0063] ** Those are the GPC Mm of the main peak corresponding to (SI/B)$_2$, (SI/B)$_3$ and (SI/B)$_4$ present in the ratio close to 1.5/5/0.5

*** (SI/B)x % w with x>1

**Table 3**

| Mineral plasticizer: | ONDINA™ N68 a fully hydrogenated naphthenic mineral oil (Shell) |
|---|---|
| Photo initiator: | IRGACURE™ 651 a 2,2-dimethoxy-1,2-diphenyl ethan-1-one (Ciba Speciality Chemicals) |
| Antioxidant: | IRGANOX™ 1010 a tetrakisethylene-(3,5-di-tertiary-butyl-4-hydroxy-hydrocinnamate)methane (Ciba speciality chemicals) |

MIXING PROCESS

The solid rubber(s) and the plasticiser were dry mixed at room temperature. After hand mixing the 'dry mixed' ingredients were poured into the internal mixer cup rotating at 50 rpm and preheated at 140°C. Eventual liquid rubbers were then added to the cup. Once all previous ingredients were introduced, the reactive monomers were added. The mixing proceeded then for 4 minutes and the eventual photoinitiator was then added followed by an additional minute of mixing. The torque required to mix the ingredients was sometimes recorded at the final stage. The measured torque is a direct indication of the mixture viscosity since the rotation speed is constant and since the cup is always containing the same amount of ingredients (the ingredients represent in all cases 90% of the internal mixer volume). The homogenised mixture was then removed from the internal mixer and cooled down to room temperature.

PLATE PRODUCING PROCESS

Hot mixed compositions were shaped into plates in a hot hydraulic press (Schwabenthan press). The required amount of the composition was put inside an insert of the final required thickness and surrounded on top and bottom by release paper. The composition was then heated up to 140°C and compressed up to 1 MPa pressure. This pressure was maintained for a minute. The photo-curable plate thus obtained was about 2 mm thick. This hot plate was sometimes repressed between two PET films.

The plate was stored in the darkness, since the presence of photo initiator and photopolymerisable monomer makes the plates sensitive to curing in daylight

CURING PROCESS

The plate was cured with a 300 W/inch (300 W/2.5 cm) UV mercury medium pressure lamp from American UV Company. Samples were passed a specified number of times under the lamp at a speed of 10 m/min. For multiple passes, the sample was turned upside down after each pass.

A UV compact radiometer (ex UV Process Supply Inc.) was used to check the UV dose corresponding to the above curing process. One pass under the lamp without any film barrier was measured at around 350mJ/cm$^2$.

CHARACTERISATION TESTS:

MELT FLOW RATE

The melt flow rate was measured according to ISO 1333 with 200°C/5 kg conditions. The results are expressed in grams of polymer that flew out in 10 minutes (g/10 min).

HAZE

Haze was measured according to ASTM D1003 on a Colorquest II.

REFLECTANCE

REFLECTANCE was measured with 'THE ColorQUEST' in the reflectance 45/0 Observer 2° mode (incident light angle = 45° reflectance observed perpendicular to the panel). The machine was standardised following the required procedure. The sample was measured with the standard black panel as background. The standard black panel giving 0% reflectance, any reflected light at 400nm is due to scattering inside the rubber plate.

UV TRANSMISSION LEVEL

The UV transparency/transmission measured the fraction of UV light transmitted through the measured plate (of fixed thickness=2mm). The plate lying on the UV compact radiometer passed under the UV lamp described above in CURING PROCESS. The ratio of the UV intensity in the presence and absence of the plate gave the UV transmission level. If the plate was surrounded by 2 PET films, the intensity without plate was measured through 2 PET film.

At low level of UV absorption, the UV scattering is given by 100%-UV transmission (%).

HARDNESS

Shore A hardness was determined after 27s (sometimes 3s) penetration of the needle type A in the sample and in accordance with ASTM D 2240.

GEL CONTENT

A known amount of the measured plate was soaked in a large amount of toluene for one night. The not dissolved mass was filtered off and dried at 70°C under vacuum until no further weight loss occurred. The gel content was calculated via: gel content (%)=$W_{(dried)}$/$W_{(initial)}$ * 100 with $W_{(initial)}$ bering the weight of the cured plate prior to dissolving in toluene, and $W_{(dried)}$ being the weight of the cured plate after dissolving in toluene and drying.

SWELLING in TOLUENE

The swelling in toluene assesses the cross-link density of the gel fraction after curing. To measure the swelling in toluene, a known amount of the plate was soaked in toluene for one night. The solution was filtered and the swelled insoluble fraction on the filter was weighted giving W . The same not dissolved mass was dried at 70°C under vacuum until no further weight loss occurred. The swelling in toluene was calculated via: Swelling in toluene (%) = $W_{(swell)}$/$W_{(dried)}$ * 100.

With respect to transparency and melt stability the following is observed. Both SIS and SBS are known to lead to very transparent flexographic plates. Both the pure SIS and the pure SBS lead respectively here to 2.9 and 1.7% reflectance. Unfortunately, straight mixtures of those two rubbers give low transparency, high reflectance properties (above 3% reflectance). The highest (worse) reflectances are found in the range 20/80-80/20 and more especially in the 30/70 - 70/30 ratios. :

**Table 4**

| SIS1/SBS1 weight ratio (w%) | Reflectance at 400nm (%) |
|---|---|
| 100/0 | 2.9 |
| 90/10 | 4.0 |
| 80/20 | 3.7 |
| 70/30 | 4.5 |
| 60/40 | 7.4 |
| 40/60 | 6.5 |

(continued)

| SIS1/SBS1 weight ratio (w%) | Reflectance at 400nm (%) |
|---|---|
| 30/70 | 5.7 |
| 20/80 | 3.7 |
| 10/90 | 2.6 |
| 0/100 | 1.7 |
| Blanco | 0.0 |

The sample reflectance is not at all a linear function of the blend composition. The reflectance shows a large maximum around 50/50 ingredient ratio and is too high in the range 20/80 to 80/20. That range corresponds to white 'milky' haze in the sample. To get really transparent and non-scattering samples, nearly pure SIS or SBS binder must be used. The user therefore has no access to intermediate formulations with acceptable high transparency/low reflectance, albeit that such intermediate formulations are desirable for several reasons. For instance, this would allow far more flexibility for the formulator to combine specific characteristics of the SIS and the SBS families.

The data of table 5 demonstrate the large range of hardness and viscosity one could reach by blending SIS type polymer with SBS type polymer.

**Table 5**

| SIS1/SBS1 weight ratio | Hardness 3s (Shore A) | Torque (140°C) (N.m) |
|---|---|---|
| 100/0 | 33 | 21 |
| 90/10 | 35 | 22 |
| 80/20 | 40 | 34 |
| 70/30 | 44 | 38 |
| 60/40 | 50 | 45 |
| 40/60 | 62 | 65 |
| 30/70 | 64 | 78 |
| 20/80 | 70 | 80 |
| 10/90 | 75 | 86 |
| 0/100 | 75 | 108 |

A property where the combination would be desirable is viscosity stability during the melt processing. Once mixed and processed at high temperature, typically 140°C to 180°C, the SIS polymers have a clear tendency to degrade and drop in viscosity while the SBS polymers have a tendency to cross-link leading to increased viscosity and the creation of gels. It is here of direct interest to find systems stable in viscosity during the processing. The polymer systems from the present invention are directly solving this issue (see table 6) while keeping the excellent transparency properties of the pure SIS and SBS systems (see table 7)

**Table 6**

| MFR(200°C,5kg) (g/10min) | pure SIS1 | pure SBS2 | SBS1 (67%) +oil (33%) | pure S(I/B)S1 | pure S(I/B)S3 |
|---|---|---|---|---|---|
| MFR(4min) (ISO1133) | 8,4 | 8,0 | 14,6 | 7,2 | 6,8 |
| MFR(16min) | 8,8 | 6,2 | 12,9 | 7,1 | 6,1 |
| MFR change in 12min at 160°C (%) | + 5 | -23 | -12 | -1 | -10 |
| Gel %w (2h at 160°C) | <1 | 2,7 | <1 | <1 | <1 |
| Gel %w (2h at 160°C +4h at 180°C) | <1 | 13,5 | <1 | 1,2 | 2,9 |
| Plate aspect (2h at 160°C) | **very sticky** | dry | dry | dry | dry |

(continued)

| MFR(200°C,5kg) (g/10min) Plate aspect (2h at 160°C+ 4h at 180°C) | pure SIS1 | pure SBS2 | SBS1 (67%) +oil (33%) | pure S(I/B)S1 | pure S(I/B)S3 |
|---|---|---|---|---|---|
| | **very sticky, greasy** | dry | dry, **brownish** | dry | dry |

The Melt Flow Rate (ISO 1133 200°C/5kg) measured after 4 minutes of heating on SIS1, SBS2, S(I/B)S1, S (I/B)S3 are acceptable. The SBS1 being too viscous was measured while extended with plasticizer. Leaving those materials at 200°C for additional 12 minutes demonstrated the degradation phenomena in the melt. The SIS was increasing in flow demonstrating the chain scission, while both SBS systems clearly decreased in flow. The two S(I/B)S were clearly better in stability than both SBS. Plates of the same polymer were pressed and kept for 2 hours at 160°C. This second ageing test lead to very clear gel formation in the SBS2 while led to very sticky SIS plate. A further extremely tough ageing test (2 h at 160°C plus 4 hours at 180°C) demonstrated the excellent stability of the S(I/B)S (remained dry in touch while generating no gel in normal degradation condition and low gel in very tough conditions).

<u>Table 7 :</u>

Mixtures of SIS + SBS are not acceptable due to their bad transparency. Conversely, S(I/B)S alone or in mixture with SIS and/or SBS gives transparent rubber plates.

**Table 7**

| Rubber plate composition | UV not transmitted 'scattered' | UV Transmittance | Hardness Shore A |
|---|---|---|---|
| Comparative rubber composition | 100%- Tr% | Tr % | |
| SIS1 | 11 | 89 | 33 |
| SBS1 | 0 | 100 | 74 |
| SBS2 | 11 | 89 | 68 |
| SBS1 + SBS2 ; 50/50 | 10 | 90 | 74 |
| SIS1 + SBS1 ; 50/50 | 52 | 48 | 55 |
| SIS1 + SBS2 ; 50/50 | 41* | 59 | 55 |
| Rubber composition suitable for the invention | | | |
| S(I/B)S1 | 19 | 81 | 49 |
| S(I/B)S1 +SIS1 ; 50/50 | 15 | 85 | 41 |
| S(I/B)S1 + SBS1; 50/50 | 10 | 90 | 61 |
| S(I/B)S1 + SBS2 ; 50/50 | 9 | 91 | 59 |
| S(I/B)S3 + SIS1 ; 50/50 | 7 | 93 | 40 |
| S(I/B)S3 + SBS1; 50/50 | 4 | 96 | 56 |
| S(I/B)S1+SIS1+SBS2; 33/33/33 | 27* | 73 | 48 |
| S(I/B)S2+SBS1+oil; 37.5/37.5/25 | 14 | 86 | 44 |
| S(I/B)S1+LiqSI ; 85/15 | 16 | 84 | 33 |
| S(I/B)S1+LiqPB ; 85/15 | 11 | 89 | 30 |

**[0094]** * By comparing the two asterisked samples, we can directly observe the positive compatibilisation effect of the SIBS1 for the SIS1+SBS2 system. The absolute level of UV transmittance while acceptable is borderline showing the necessity to use at least 30% of SIBS in the rubber mixtures.

The final two examples demonstrated that liquid rubbers of both PI or PB natures lead to transparent systems once compounded with SIBS type block copolymers.

The following compositions describe fully formulated compositions according to the invention compared to existing fully formulated comparative compositions.

<u>Table 8 :</u>

The formulation/process used in the following table is Rubber(s) 89%+ HDDA 10% + 1% IRGACURE™ 651 mixed and UV cured

**Table 8**

| Composition number | Rubber(s) nature | Properties | | |
|---|---|---|---|---|
| | (% by weight in rubber) | Average reflectance % (400nm light) | Toluene Gel % | Toluene swell % |
| 1* | SIS1 50% + SBS1 50% | **7.7** | 99 | 417 |
| 2* | SIS1 50% + SBS2 50% | **12.3** | 98 | 446 |
| 3 | S(I/)BS1 100% | 1.8 | 98 | 468 |
| 4 | S(I/B)S1 50% + SIS1 50% | 2.1/2.2 | 98/98 | 470/464 |
| 5 | S(I/B)S1 50% + SBS2 50% | 1.9 | 98 | 457 |

[0100]   * denotes a comparative composition

Compositions 3, 4 and 5 demonstrate the superior transparency of the S(I/B)S based formulation as compared to compositions 1* and 2* without S(T/B)S but based on mixture of SIS with SBS polymers. Gel % and swelling levels are close in all cases.

Table 9 :

In addition to processing stability problems, the composition 11* shows a non attractive viscosity once compared to the composition 9, composition 10, a slightly lower oil content version of composition 9 allows to retrieve the mechanical properties (and similar viscosity) of the comparative composition 11*, but with a higher (better) cured gel content. The composition 6 demonstrates that, in addition to the reduced stickiness, S(I/B)S can lead to higher hardness cured plates as compared to the composition 12* using SIS while exhibiting similar processing viscosities.

**Table 9**

| | 6 | 7 | **8*** | 9 | 10 | **11*** | **12*** |
|---|---|---|---|---|---|---|---|
| S(I/B)5 1 | 100 | 100 | | | | | |
| S(I/B)S2 | | | | 100 | 100 | | |
| SIS1 | | | 60 | | | | 100 |
| SBS1 | | | 40 | | | 100 | |
| ONDINA N68 | | 20 | 20 | 60 | 40 | 60 | |
| HDDA | 10 | 10 | 10 | 10 | 10 | 10 | 10 |
| IRGACURE 651 | 2 | 2 | 2 | 2 | 2 | 2 | 2 |
| IRGANOX 1010 | 1 | 1 | 1 | 1 | 1 | 1 | 1 |
| Torque N.m | 11.2 | 6.4 | 8.2 | 1.9 | 7.0 | 7.0 | 10.0 |
| Light (400nm) reflectance % | 2.2 | 1.8 | **6.7** | | | | |
| Hardness Shore A (3s) Non cured | 29 | 23 | 21 | 24 | 29 | 28 | 24 |
| Hardness Shore A 8 UV passes | 54 | 43 | 40 | 44 | 49 | 47 | 42 |
| Hardness Shore A 24 UV passes | 65 | 52 | 50 | 48 | 55 | 54 | 50 |
| Calc max gel | 97 | 83 | 83 | 64 | 72 | 64 | 97 |
| Gel %w 8 UV passes | 95 | 81 | 81 | 62 | 70 | 63 | 94 |
| Swelling %w 8 UV passes | 687 | 880 | 955 | 1380 | 1225 | 1245 | 660 |
| Swelling %w 24 UV passes | 496 | 623 | 628 | 930 | 873 | 890 | 485 |

[0105]   * denotes a comparative composition.

Composition 6/composition 8*: at close viscosities, composition 6 gives far better transparency and solvent resistance.

Composition 7/composition 8*: while leading to very close hardness and solvent properties, composition 7 exhibits a lower viscosity and specially a far better transparency.

## Technical Field

The present invention relates to photopolymerizable compositions, to flexographic printing plates to be derived from said compositions and to flexographic printing relief forms prepared from said plates.

More in particular, the present invention relates to compositions showing an improved combination of processing stability, transparency and low melt viscosity, and to flexographic printing plates showing an improved combination of transparency, hardness and solvent resistance.

## Claims

1.   Photopolymerizable composition, which comprises:

   (a) from 20 to 98.9 % by weight, based on the weight of components (a) and (b) of one or more thermoplastic elastomeric block copolymers comprising a thermoplastic elastomeric block copolymer of the formulae

$$A\text{-}C\text{-}A \ (1) \ or \ (A\text{-}C)_n X \ (2)$$

   wherein each A independently represents a polymer block of predominantly a monovinyl aromatic hydrocarbon having an apparent molecular weight in the range of from 7,000 to 25,000, wherein n is an integer equal to or greater than 2 and wherein X is the residue of a coupling agent, and wherein each C independently represents a substantially random copolymer block (I/B) of predominantly isoprene and butadiene in a mutual weight ratio in the range of from 20/80 to 80/20, wherein said polymer block C has a glass transition temperature (Tg) of at most 0°C, (determined according to ASTM E-1356-98), and having a vinyl bond content (the 1,2 and/or 3,4-addition polymerization of the isoprene and butadiene) in the range of from 5 to 70 mole%, said thermoplastic block copolymer having a poly(monovinyl aromatic hydrocarbon) content in the range of from 10 to 45 wt% and having an apparent molecular weight of the complete block copolymer in the range of from 100,000 to 1,500,000,
   (b) from 1 to 60 % by weight, based on the weight of components (a) and (b), of one or more photopolymerizable ethylenically unsaturated low molecular weight compounds,
   (c) from 0.1 to 10 % by weight, based on the total photomerizable composition of one or more polymerization initiators, and optionally
   (d) from 0 to 40 % by weight, based on the total photopolymerizable compositions, of one or more auxiliaries.

2.   Photopolymerizable composition according to claim 1, wherein thermoplastic elastomeric block copolymer of the formulae

$$A\text{-}C\text{-}A \ (1) \ or \ (A\text{-}C)_n X \ (2)$$

   comprises at least 30% by weight of said component (a).

3.   Photopolymerizable composition according to any one of claims 1 and 2, wherein the weight proportions of component (a) are in the range of from 20 to 80 wt%.

4.   Photopolymerizable composition according to any one of claims 1-3, wherein the mutual weight ratio between isoprene and butadiene in the I/B blocks is in the range according to the equation:

$$-30 < 40 + V\text{-}I < 30$$

   wherein I is the isoprene content in the I/B block and "V" is the molar ratio in percent of 1,2 or 3,4 addition polymerization in the I/B blocks.

5.   Photopolymerizable composition according to any one of claims 1-4, wherein component (b) is selected from esters or amides of acrylic acid or methacrylic acid with monofunctional or polyfunctional alcohols, amines, aminoalcohols and hydroxyl ethers or hydroxyl esters.

6. Photopolymerizable composition according to claim 5, wherein component (b) is selected from butyl acrylate, isodecyl acrylate, trimethylolpropane triacrylate and dipentaerythritol monohydroxypentacrylate.

7. Photopolymerizable composition according to any one of claims 1-6, wherein the weight proportions of component (b) are in the range of from 5 to 30 % by weight, relative to the weight of components (a) and (b).

8. Photopolymerizable composition according to any one of claims 1-7, wherein the weight proportions of component (c) are in the range of from 0.5 to 5% by weight, relative to the weight of the total copolymerizable composition.

9. Flexographic printing plate derived from photopolymerizable composition according to any one of claims 1-8.

10. Flexographic printing relief forms, prepared from flexographic a printing plate according to claim 9.


**Patentansprüche**

1. Photopolymerisierbare Zusammensetzung, umfassend:

(a) 20 bis 98,9 Gewichts-%, basierend auf dem Gewicht der Bestandteile (a) und (b), eines oder mehrerer thermoplastischer elastomerer Blockcopolymere, umfassend ein thermoplastisches elastomeres Blockcopolymer der Formeln:

$$A-C-A \ (1) \ oder \ (A-C)_n X \ (2)$$

wobei jedes A unabhängig voneinander einen Polymerblock aus überwiegend einem monovinylaromatischen Kohlenwasserstoff mit einem scheinbaren Molekulargewicht im Bereich von 7.000 bis 25.000 darstellt, wobei n eine ganze Zahl gleich oder größer als 2 ist und wobei X der Rest eines Kopplungsmittels ist, und wobei jedes C unabhängig voneinander einen im Wesentlichen statistischen Copolymerblock (I/B) aus überwiegend Isopren und Butadien in einem wechselseitigen Gewichtsverhältnis im Bereich von 20/80 bis 80/20 darstellt, wobei der Polymerblock C eine Glasübergangstemperatur (Tg) von höchstens 0 °C aufweist (bestimmt gemäß ASTM E-1356-98), und einen Vinylbindungsgehalt (die 1,2- oder 3,4-Additionspolymerisation von Isopren und Butadien) im Bereich von 5 bis 70 Mol-% aufweist, wobei das thermoplastische Blockcopolymer einen Gehalt an Poly (vinylaromatischem Kohlenwasserstoff) im Bereich von 10 bis 45 Gewichts-% aufweist und ein scheinbares Molekulargewicht des vollständigen Blockcopolymers im Bereich von 100.000 bis 1.500.000 aufweist,

(b) 1 bis 60 Gewichts-%, basierend auf dem Gewicht der Bestandteile (a) und (b), eines oder mehrerer photopolymerisierbarer ethylenisch ungesättigter Verbindungen mit niedrigem Molekulargewicht,

(c) 0,1 bis 10 Gewichts-%, basierend auf der gesamten photopolymerisierbaren Zusammensetzung, eines oder mehrerer Polymerisationsinitiatoren, und wahlweise

(d) 0 bis 40 Gewichts-%, basierend auf der gesamten photopolymerisierbaren Zusammensetzung, eines oder mehrerer Hilfsstoffe.

2. Photopolymerisierbare Zusammensetzung nach Anspruch 1, worin das thermoplastische elastomere Blockcopolymer der Formeln

$$A-C-A \ (1) \ oder \ (A-C)_n X \ (2)$$

wenigstens 30 Gewichts-% des Bestandteils (a) umfasst.

3. Photopolymerisierbare Zusammensetzung nach einem der Ansprüche 1 und 2, worin der Gewichtsanteil des Bestandteils (a) im Bereich von 20 bis 80 Gewichts-% liegt.

4. Photopolymerisierbare Zusammensetzung nach einem der Ansprüche 1 bis 3, worin das wechselseitige Gewichtsverhältnis zwischen Isopren und Butadien in den I/B-Blöcken im Bereich gemäß der Gleichung

$$-30 < 40 + V - 1 < 30$$

liegt, wobei I der Isoprengehalt in dem I/B-Block und "V" das prozentuale Molverhältnis der 1,2- oder 3,4-Additionspolymerisation in den I/B-Blöcken ist.

5. Photopolymerisierbare Zusammensetzung nach einem der Ansprüche 1 bis 4, worin der Bestandteil (b) aus Estern oder Amiden der Acrylsäure oder Methacrylsäure mit monofunktionellen oder polyfunktionellen Alkoholen, Aminen, Aminoalkoholen und Hydroxylethern oder Hydroxylestern ausgewählt ist.

6. Photopolymerisierbare Zusammensetzung nach Anspruch 5, worin der Bestandteil (b) aus Butylacrylat, Isodecylacrylat, Trimethylolpropantriacrylat und Dipentaerythritolmonohydroxypentacrylat ausgewählt ist.

7. Photopolymerisierbare Zusammensetzung nach einem der Ansprüche 1 bis 6, worin der Gewichtsanteil des Bestandteils (b) im Bereich von 5 bis 30 Gewichts-%, bezogen auf das Gewicht der Bestandteile (a) und (b), liegt.

8. Photopolymerisierbare Zusammensetzung nach einem der Ansprüche 1 bis 7, worin der Gewichtsanteil des Bestandteils (c) im Bereich von 0,5 bis 5 Gewichts-%, bezogen auf das Gewicht der gesamten copolymerisierbaren Zusammensetzung, liegt.

9. Flexodruckplatte, die von der photopolymerisierbaren Zusammensetzung nach einem der Ansprüche 1 bis 8 abgeleitet ist.

10. Relief-Flexodruckformen, die von der Flexodruckplatte nach Anspruch 9 hergestellt werden.

**Revendications**

1. Composition photopolymérisable, qui comprend :

(a) 20 à 98,9 % en poids, sur la base du poids des composants (a) et (b), d'un ou plusieurs copolymères séquencés élastomères thermoplastiques comprenant un copolymère séquencé élastomère thermoplastique répondant aux formules suivante

$$A\text{-}C\text{-}A \ (1) \ \text{ou} \ (A\text{-}C)_n X \ (2)$$

dans lesquelles chaque terme A représente indépendamment
une séquence polymère constituée de manière prédominante d'un hydrocarbure aromatique monovinylique présentant un poids moléculaire apparent dans la plage de 7000 à 25 000, dans lesquelles n est un nombre entier supérieur ou égal à 2 et dans lesquelles X est le résidu d'un agent de couplage, et dans lesquelles chaque terme C représente indépendamment une séquence polymère sensiblement aléatoire (I/B) contenant de manière prédominante de l'isoprène et du butadiène dans un rapport pondéral mutuel dans la plage de 20/80 à 80/20, dans lesquelles ladite séquence polymère C présente une température de transition vitreuse (Tg) de 0 °C au maximum (déterminée selon la norme ASTM E-1 356-98), et présentant une teneur en liaison vinyle (polymérisation par addition de type 1,2 et/ou 3,4 de l'isoprène et du butadiène) dans la plage de 5 à 70 % en mole, ledit copolymère séquencé thermoplastique présentant une teneur en poly(hydrocarbure aromatique monovinylique) dans la plage de 10 à 45 % en poids et présentant un poids moléculaire apparent, pour la totalité du copolymère séquencé, dans la plage de 100 000 à 1 500 000,
(b) 1 à 60 % en poids, sur la base du poids des composants (a) et (b), d'un ou plusieurs composés photopolymérisables à insaturation éthylénique et de faible poids moléculaire,
(c) 0,1 à 10 % en poids, sur la base de la totalité de la composition photopolymérisable, d'un ou plusieurs initiateurs de polymérisation, et éventuellement
(d) 0 à 40 % en poids, sur la base de la totalité des compositions photopolymérisables, d'un ou plusieurs agents auxiliaires.

2. Composition photopolymérisable selon la revendication 1, dans laquelle le copolymère séquencé élastomère thermoplastique répondant aux formules suivantes :

$$A\text{-}C\text{-}A \ (1) \ \text{ou} \ (A\text{-}C)_n X \ (2)$$

comprend au moins 30 % en poids dudit composant (a).

3.  Composition photopolymérisable selon l'une quelconque
    des revendications 1 et 2,
    dans laquelle les proportions en poids du composant (a)
    se situent dans la plage de 20 à 80 % en poids.

4.  Composition photopolymérisable selon l'une quelconque des revendications 1 à 4, dans laquelle le rapport pondéral mutuel entre l'isoprène et le butadiène dans les séquences I/B se situe dans la plage satisfaisant l'équation suivants :

$$-30 < 40 + V - I < 30$$

dans laquelle le terme I désigne la teneur en isoprène dans la séquence I/B et le terme "V" représente le rapport molaire exprimé en pourcentage de polymérisation par addition de type 1,2 ou 3,4 dans les séquences I/B.

5.  Composition photopolymérisable selon l'une quelconque des revendications 1 à 4, dans laquelle le composant (b) est sélectionné parmi des esters ou des amides d'acide acrylique ou d'acide méthacrylique avec des alcools, des amines, des aminoalcools et des hydroxyléthers ou hydroxylesters monofonctionnels et polyfonctionnels.

6.  Composition photopolymérisable selon la revendication 5, dans laquelle le composant (b) est sélectionné parmi l'acrylate de butyle, l'acrylate d'isodécyle, le triacrylate de triméthylolpropane et le monohydroxypentacrylate de dipentaérythritol.

7.  Composition photopolymérisable selon l'une quelconque des revendications 1 à 6, dans laquelle les proportions en poids du composant (b) se situent dans la plage de 5 à 30 % en poids par rapport au poids des composants (a) et (b).

8.  Composition photopolymérisable selon l'une quelconque des revendications 1 à 7, dans laquelle les proportions en poids du composant (c) se situent dans la plage de 0,5 à 5 % en poids par rapport au poids de la composition copolymérisable totale.

9.  Plaque d'impression flexographique dérivée d'une composition photopolymérisable selon l'une quelconque des revendications 1 à 8.

10. Formes d'impression flexographiques en relief préparées à partir d'une plaque d'impression flexographique selon la revendication 9.

**EP 1 499 923 B1**

**REFERENCES CITED IN THE DESCRIPTION**

**Patent documents cited in the description**

- GB 1366769 A
- US 4266005 A
- US 4320188 A
- US 4126466 A
- US 4430417 A
- US 4460675 A
- US 5213948 A
- EP 0084851 A
- EP 0525206 A
- WO 02057386 A
- EP 0691991 A
- US 5472824 A